# EUROPÄISCHE PATENTANMELDUNG

(11) **EP 0 825 449 A1**
(43) Veröffentlichungstag der Anmeldung: **25.02.1998**
(21) Anmeldenummer: 96113303.0
(22) Anmeldetag: 19.08.1996
(51) Int. Cl.: G01R 15/18

(54) **Strom-Messverfahren und -einrichtung**

(71) Anmelder: SIEMENS AKTIENGESELLSCHAFT, 80333 München (DE)
(72) Erfinder: Zierhut, Hermann, Dipl.-Ing., 93073 Neutraubling (DE)

(57) **Zusammenfassung**

Bei einem Verfahren zum Messen von Strömen mit einem Übertrager (1), bei dem ein zu messender Primärstrom durch eine Primärwicklung (2) und ein entsprechender Strom durch eine Sekundärwicklung (3) fließt, ergeben sich sehr genaue Meßwerte ohne Beeinflussung durch den Magnetisierungsfluß des Übertragers (1) bei Aufprägen eines Kompensationsstromes auf die Sekundärwicklung (3), der dem durch den Primärstrom in der Sekundärwicklung (3) bewirkten Strom gleich, jedoch entgegengesetzt gerichtet ist. Eine Strom-Meßeinrichtung zur Durchführung des Meßverfahrens ist angegeben. Mit einer derartigen Meßeinrichtung sind neben den genannten Verfahrensvorteilen auch Übertrager mit kleinen Volumen und reduzierten Eisenkernen möglich.

## Beschreibung

Die Erfindung betrifft ein Verfahren und eine Einrichtung zum Messen von Strömen mit einem Übertrager, wobei ein zu messender Primärstrom durch eine Primärwicklung und ein entsprechender Strom durch eine Sekundärwicklung fließt.

Derartige Verfahren bzw. Meßeinrichtungen sind als Stromsensoren bekannt und werden beispielsweise von der Firma Coilcraft, Cary, USA, auf dem Markt angeboten. Eine solche Meßeinrichtung stellt einen Stromwandler mit einem Abschlußwiderstand von geringem Widerstandswert, beispielsweise von 10 bis 100 Ohm dar. Das Windungsverhältnis des Übertragers liegt dabei in einem Bereich von 1:100 bis 1:500, wobei der zu messende Strom durch die Primärwicklung fließt, die üblicherweise nur aus einer Windung besteht. Die Sekundärwicklung wird mit dem Abschlußwiderstand beschaltet, über dem eine Spannung abgegriffen wird und die auf Grund der Proportionalität ein Maß für die Stromstärke der Primärwicklung ist. Der für den Übertrager erforderliche Magnetisierungsstrom beeinflußt jedoch die Meßgenauigkeit nachteilig. Dies gilt insbesondere bei kleinen Strömen, bei denen der erforderliche Magnetisierungsstrom für den Übertrager in der Größenordnung des Nutzstromes liegt. Dadurch ist eine genaue Strommessung bei derartigen Stromwandlern - wenn überhaupt - nur mit einer sehr aufwendigen Kalibrierung möglich. Ein weiterer Nachteil derartiger Stromsensoren besteht darin, daß die Skalierung nicht linear ist, was in vielen Anwendungsfällen wünschenswert wäre.

Der Erfindung liegt daher die Aufgabe zugrunde, ein Verfahren der eingangs genannten Art zu schaffen, sowie eine StromMeßeinrichtung anzugeben, mit der die Genauigkeit der Strommessung wesentlich verbessert werden kann, ohne daß dafür ein größerer schaltungstechnischer oder Kalibrierungsaufwand getrieben werden muß.

Die gestellte Aufgabe wird erfindungsgemäß dadurch gelöst, daß der Sekundärwicklung ein Kompensationsstrom aufgeprägt wird, der dem durch den Primärstrom in der Sekundärwicklung bewirkten Strom gleich, jedoch entgegengesetzt gerichtet ist.

Durch die erfindungsgemäße Maßnahme, den Sekundärstrom des Übertragers durch einen entgegengesetzt gerichteten Strom mit gleicher Amplitude - nachfolgend als Kompensationsstrom bezeichnet - zu kompensieren, tritt an den Klemmen der Sekundärwicklung kein Spannungsabfall auf. Dadurch wird erreicht, daß der magnetische Fluß im Eisenkern des Übertragers und damit der Magnetisierungsstrom sehr gering, wenn nicht gar Null, wird und daher die Messung nicht fehlerbehaftend beeinflußt. Die Meßgenauigkeit des erfindungsgemäßen Verfahrens wird daher erheblich verbessert.

Die gestellte Aufgabe wird auch mit einer Strom-Meßeinrichtung der eingangs genannten Art gelöst, bei der erfindungsgemäß eine sekundärseitige Stromquelle vorgesehen ist, mit der der Sekundärwicklung ein Kompensationsstrom aufgeprägt wird, der dem durch den Primärstrom in der Sekundärwicklung bewirkten Strom gleich, jedoch entgegengesetzt gerichtet ist. Durch den von der sekundärseitigen Stromquelle bereitgestellten Kompensationsstrom wird wiederum erreicht, daß der Spannungsabfall an der Sekundärseite Null oder nahezu Null ist, wodurch die bereits beschriebenen Vorteile erreicht werden.

Die erfindungsgemäße Strom-Meßeinrichtung weist darüber hinaus gegenüber herkömmlichen Einrichtungen dieser Art den Vorteil auf, daß der Übertrager ein kleines Volumen aufweist und mit einem kleinen Eisenkern auskommt, weil der magnetische Kraftfluß im Eisenkern auf Grund der Kompensation der Ströme in der Sekundärwicklung klein bleibt.

Gemäß einer vorteilhaften Ausführungsform der Erfindung wird der Stromwert des Kompensationsstromes als Meßgröße für den Primärstrom erfaßt. Dies ist deshalb möglich, weil der Kompensationsstrom im wesentlichen dem in der Sekundärwicklung durch den zu messenden Primärstrom hervorgerufenen Strom in seinem Betragswert gleich ist.

Gemäß einer besonders vorteilhaften Ausgestaltung der Erfindung umfaßt die Stromquelle einen Operationsverstärker. Dadurch läßt sich eine Stromquelle mit geringem schaltungstechnischen Aufwand realisieren.

Vorzugsweise sind die Anschlüsse der Sekundärwicklung des Übertragers mit Eingängen des Operationsverstärkers verbunden. Dabei weist der Operationsverstärker vorteilhafterweise einen Rückkoppelzweig auf, der den Ausgang des Operationsverstärkers mit einem seiner Eingänge verbindet.

Der Kompensationsstrom, der - wie zuvor ausgeführt wurde - ein Maß für den zu messenden Primärstrom ist, kann auf verschiedene Weise sekundärseitig gemessen werden. Gemäß einem besonders vorteilhaften Ausführungsbeispiel ist im Rückkoppelzweig des Operationsverstärkers ein Meßwiderstand vorgesehen, an dem eine dem Rückoppelstrom proportionale Spannung abgreifbar ist, die wiederum dem zu messenden Primärstrom proportional ist.

Gemäß einer besonders vorteilhaften Ausführungsform der Erfindung ist in wenigstens einem Eingangszweig des Operationsverstärkers eine Schaltungsstufe zur Gleichtaktunterdrückung vorgesehen. Auf diese Weise ist es mit einfachen Mitteln möglich, eine Eingangs-Offsetspannung zu unterdrücken.

Eine weitere vorteilhafte Ausgestaltung der erfindungsgemäßen Strom-Meßeinrichtung besteht darin, daß der Übertrager eine zweite Sekundärwicklung aufweist, über die der Kompensationsstrom fließt. Dies ist insbesondere dann von Vorteil, wenn die Strom-Meßeinrichtung für große Meßbereiche vorgesehen ist.

Insbesondere dann, wenn ein Gleichrichtwert entsprechend der Messung mit einem Drehspulgleichrichter-Instrument ermittelt werden soll, ist es vorteilhaft, zwischen der sekundärseitigen Stromquelle, beispielsweise einem Operationsverstärker und wenigstens einer Sekundärwicklung eine Gleichrichterschaltung vorzusehen. Die Gleichrichterschaltung kann passive oder aktive Ventile in der üblichen Weise aufweisen.

Für den praktischen Anwendungsfall ist es besonders vorteilhaft, wenn bei mehreren Übertragern an unterschiedlichen Meßorten diese jeweils wahlweise mit derselben sekundärseitigen Stromquelle verbindbar sind. Auf diese Weise wird der schaltungstechnische Aufwand für die Messung bzw. Überwachung von Strömen an unterschiedlichen Meßorten wesentlich verringert. Vorteilhaft ist es dabei, eine Bus-Leitung zur Verbindung der an unterschiedlichen Meßorten angeordneten Übertrager mit der sekundärseitigen Stromquelle vorzusehen.

Die Erfindung sowie weitere Vorteile und Ausgestaltungen wird bzw. werden nachfolgend unter Bezugnahme auf die Figuren erläutert. Es zeigen:
- FIG 1: eine Ausführungsform der erfindungsgemäßen StromMeßeinrichtung in schematischer Darstellung;
- FIG 2: eine weitere Ausführungsform der Erfindung mit einer Schaltungsstufe zur Gleichtaktunterdrückung, in schematischer Darstellung;
- FIG 3: eine dritte Ausführungsform der Erfindung mit zwei Sekundärwicklungen:
- FIG 4: eine Ausführungsform der Erfindung mit einer Schaltungsstufe zur Gleichtaktunterdrückung und zwei Sekundärwicklungen;
- FIG 5: eine Ausführungsform der Erfindung mit einer Gleichrichterschaltung und
- FIG 6: eine Ausführungsform der Erfindung, bei der mehrere Übertrager an unterschiedlichen Meßorten über eine Bus-Leitung mit einer sekundärseitigen Stromquelle zur Erzeugung des Kompensationsstroms wahlweise verbindbar sind.

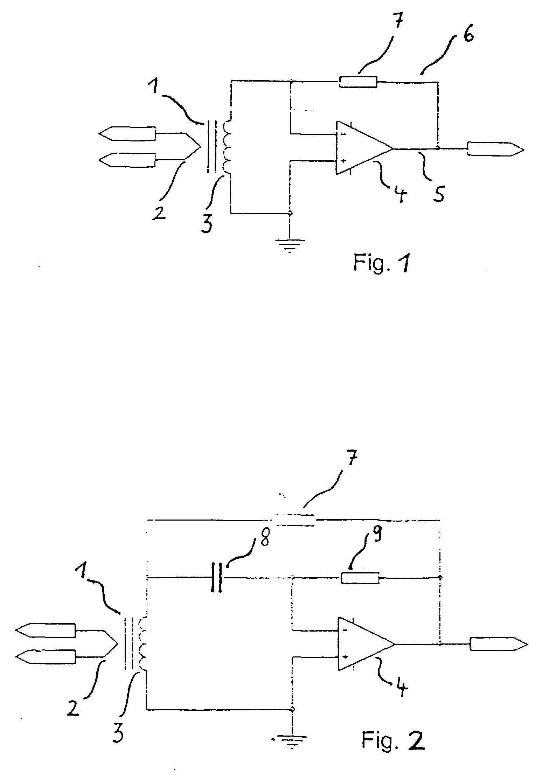

Bei der in FIG 1 dargestellten Ausführungsform der Erfindung weist ein Übertrager 1 eine Primärwicklung 2 und eine Sekundärwicklung 3 auf. Die Primärwicklung 2 ist im dargestellten Beispiel lediglich eine Windung, durch die ein zu messender Primärstrom fließt. Ein Anschluß der Sekundärwicklung 3 ist mit dem an Masse liegenden Plus-Eingang eines Operationsverstärkers 4 verbunden, während dessen Minus-Eingang am anderen Anschluß der Sekundärwicklung 3 liegt. Der Ausgang 5 des Operationsverstärkers 4 ist über einen Rückkoppelzweig 6 auf dem Minus-Eingang des Operationsverstärkers 4 rückgekoppelt, wobei im Rückkoppelzweig 6 ein Widerstand 7 liegt.

Die Operationsverstärker-Schaltung mit dem Operationsverstärker 4 dient als Stromquelle, wobei durch den Rückkoppelzweig 6 ein Strom fließt, der dem Sekundärstrom des Übertragers 1 gleich, jedoch entgegengesetzt gerichtet ist. Auf diese Weise wird der zur Magnetisierung des Eisenkerns erforderliche Strom verringert, so daß sein Einfluß auf den Nutzstrom minimiert wird.

Der Widerstand 7 im Rückkoppelkreis 6 der Operationsverstärker-Schaltung dient gemäß diesem Ausführungsbeispiel als Meßwiderstand, an dem eine Spannung abgegriffen wird, die proportional zu dem Kompensationsstrom und damit dem vom zu messenden Primärstrom bewirkten Sekundärstrom ist.

Bei dem in FIG 2 dargestellten Ausführungsbeispiel sind die Schaltungsteile, die denen von FIG 1 entsprechen, mit denselben Bezugszeichen versehen und werden nicht nochmals beschrieben. Das in FIG 2 dargestellte Ausführungsbeispiel unterscheidet sich von dem der FIG 1 lediglich darin, daß eine Schaltungsstufe zur Gleichtaktunterdrückung vorgesehen ist. Zwischen dem Minus-Eingang des Operationsverstärkers 4 und dem zugeordneten Ausgang der Sekundärwicklung 3 des Übertragers 1 ist dafür ein Kondensator 8 geschaltet, und der Serienschaltung des Kondensators 8 mit einem vorzugsweise hochohmigen Widerstand 9 liegt der Widerstand 7 des Rückkoppelzweigs 6 parallel. Durch diese Schaltungsvariante ist es möglich, Offset-Spannungen des Operationsverstärkers zu unterdrücken.

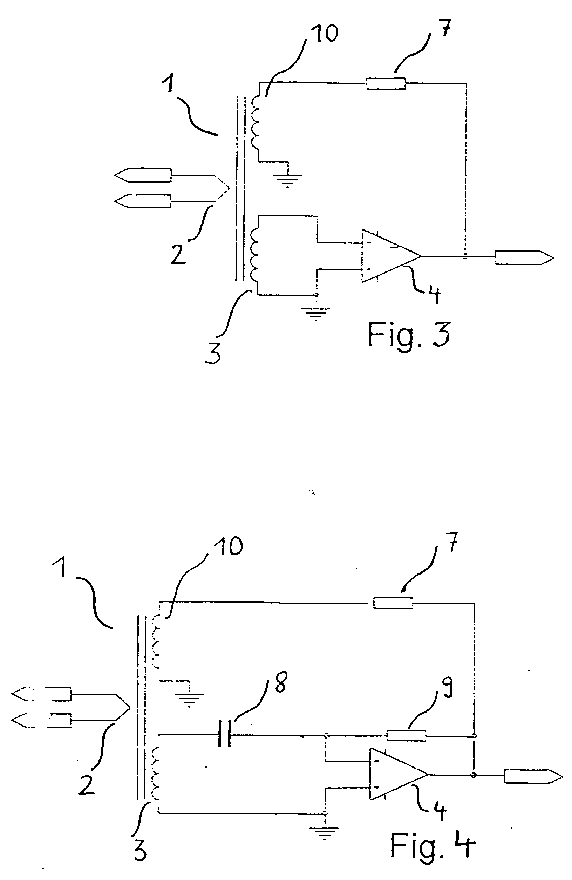

Bei der in FIG 3 dargestellten Ausführungsform der Erfindung ist zusätzlich zur Sekundärwicklung 3 des Übertragers 1 eine weitere Sekundärwicklung 10 vorgesehen. Ein Anschluß der Sekundärwicklung 10 ist über den Widerstand 7 mit dem Ausgang 5 des Operationsverstärkers 4 verbunden, während der zweite Anschluß der Sekundärwicklung 10 an Masse liegt. Ein Vorteil dieser Schaltung besteht darin, daß der Meßfehler, welcher durch den Spannungsfall am Innenwiderstand nur einer Sekundärspule entsteht, vermieden werden kann. Dies wird insbesondere dadurch erreicht, daß der Kompensationsstrom ausschließlich über die Sekundärwicklung 10 geführt wird, während die Sekundärwicklung 3 ausschließlich als Meßwicklung ausgebildet ist, in welcher nur ein Strom kleiner 1 µA fließt.

Das in FIG 4 gezeigte Ausführungsbeispiel einer Strommeßeinrichtung unterscheidet sich von der in FIG 3 gezeigten Schaltung lediglich hinsichtlich der zusätzlich vorgesehenen Schaltungsstufe zur Gleichtaktunterdrückung. Ein Kondensator 8 ist dabei zwischen einem Anschluß der Sekundärwicklung 3 und dem negativen Eingang des Operationsverstärkers 4 vorgesehen. Ein vorzugsweise hochohmiger Widerstand 9 ist ebenfalls mit dem negativen Eingang des Operationsverstärkers 4 verbunden und auf der anderen Seite am Ausgang 5 des Operationsverstärkers angeschlossen. Durch diese Art der Beschaltung kann, wie bereits oben erwähnt, eine einfache Eingangs-Offsetkorrektur des Operationsverstärkers 4 erreicht werden.

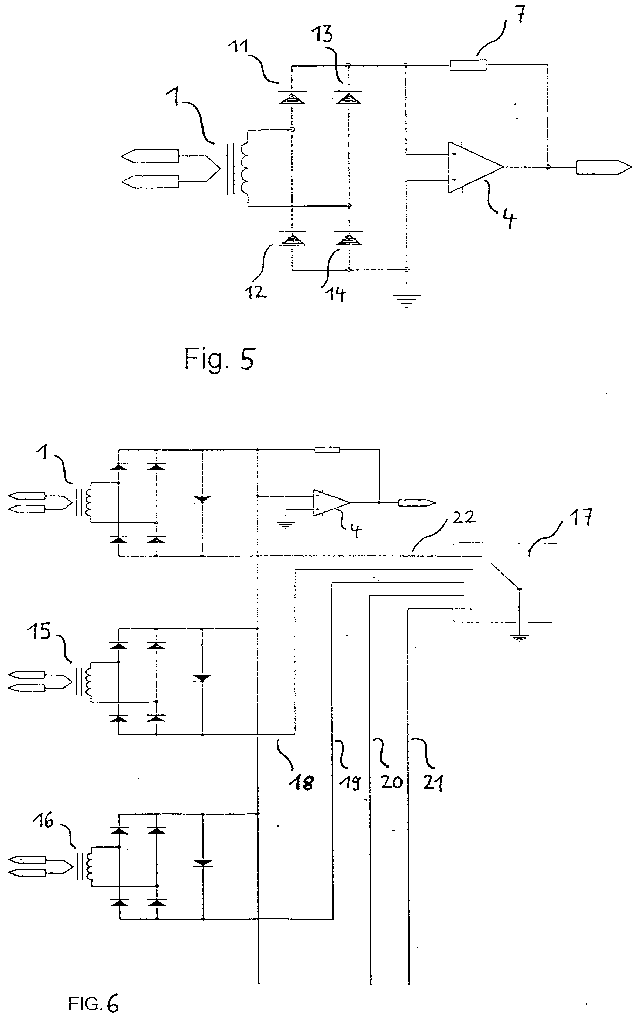

In dem Ausführungsbeispiel gemäß FIG 5 sind auf der Sekundärseite des Übertragers Gleichrichterventile 11 bis 14 vorgesehen. Bei der in der FIG 5 gezeigten Gleichrichterschaltung handelt es sich um eine Vier-Quadranten-Gleichrichterbrücke, deren ungleichnamige Anschlüsse mit der Sekundärwicklung 3 verbunden sind, und deren gleichnamige Anschlüsse entsprechend mit dem positiven und negativen Eingang des Operationsverstärkers 4 verbunden sind. Weiterhin weist das Ausführungsbeispiel nach FIG 5 einen Rückkopplungszweig 6 auf, der ebenso wie bei der in FIG 1 dargestellten Ausführungsform vom Ausgang 5 des Operationsverstärkers 4 über einen Widerstand 7 zum negativen Eingang des Operationsverstärkers führt. Mit der in FIG 5 gezeigten Schaltung ist es möglich, einen Gleichrichtwert des zu messenden Stromes zu bestimmen.

Ein weiteres Ausführungsbeispiel der vorliegenden Erfindung ist in FIG 6 gezeigt. Die Schaltung nach FIG 6 weist neben dem zuvor beschriebenen Übertrager 1 noch weitere Übertrager 15 und 16 auf, mit denen verschiedene, durch die jeweilige Primärwicklung eines jeden Übertragers fließende Ströme erfaßt werden können. Jeder der gezeigten Übertrager 3, 15 und 16 ist sekundärseitig an eine Diodenbrücke, wie im Zusammenhang mit FIG 5 erklärt, angeschlossen. Jeweils gleiche Paare gleichnamiger Anschlüsse der Diodenbrücken sind über eine Sammel- oder Bus-Leitung mit dem negativen Eingang des Operationsverstärkers 4 verbunden. Das jeweils zweite gleichnamige Paar von Anschlüssen einer jeden Diodenbrücke ist über jeweils eine weitere Leitung 18 bis 22 mit einem Schalter 17 verbunden. Durch Verbinden einer ausgewählten Leitung 18 bis 22 mit Masse wird der gewünschte Meßkreis mit der Operationsverstärkerschaltung 4, 5, 6, 7 verbunden, die dabei wie bei der anhand von FIG 1 bzw. FIG 5 beschriebenen Weise arbeitet. Ein Vorteil der in FIG 6 gezeigten Schaltung besteht darin, daß mehrere, räumlich getrennte Strommeßkreise mit ein und derselben Operationsverstärkerschaltung bzw. Stomquelle wahlweise verbunden werden können, und somit eine einfache Möglichkeit zum Erfassen von verschiedenen Strömen geschaffen wird. Besonders vorteilhaft ist diese Lösung bei Fernabfragen in verteilten Systemen, insbesondere dann, wenn verschiedene Sensoren und Aktoren über ein Bus-System miteinander verbunden sind. Der Schalter 17 ist dabei vorteilhaft als elektronischer Schalter ausgebildet, der eine logische "1-aus-n"-Funktion erfüllt, wobei n die Anzahl der Meßkreise ist.

Die Erfindung wurde zuvor anhand bevorzugter Ausführungsbeispiele beschrieben. Dem Fachmann sind jedoch zahlreiche Abwandlungen und Ausgestaltungen möglich, ohne daß dadurch der Erfindungsgedanke verlassen wird. Beispielsweise ist es möglich, den als Meßwiderstand dienenden Widerstand 7 im Rückkoppelkreis 6 des Operationsverstärkers 4 umschaltbar auszuführen, um den Meßbereich beispielsweise über mehrere Dekaden hinweg zu erweitern. Als Ausführungsmöglichkeit sind parallel zueinander liegende Widerstände mit unterschiedlichen Widerstandswerten vorteilhaft, die je nach der Wahl des Meßbereichs mit einem entsprechenden Schalter in den Rückkoppelkreis schaltbar sind.

## Patentansprüche

1. Verfahren zum Messen von Strömen mit einem Übertrager (1), wobei ein zu messender Primärstrom durch eine Primärwicklung (2) und ein entsprechender Strom durch eine Sekundärwicklung (3) fließt,
**dadurch gekennzeichnet,**
daß der Sekundärwicklung (3) ein Kompensationsstrom aufgeprägt wird, der dem durch den Primärstrom in der Sekundärwicklung (3) bewirkten Strom gleich, jedoch entgegengesetzt gerichtet ist.

2. Verfahren nach Anspruch 1,
**dadurch gekennzeichnet,**
daß der Stromwert des Kompensationsstromes als Meßgröße für den Primärstrom erfaßt wird.

3. Strom-Meßeinrichtung mit einem Übertrager (1), der eine vom zu messenden Primärstrom durchflossene Primärwicklung (1) und mindestens eine Sekundärwicklung (3) aufweist,
**gekennzeichnet durch** eine sekundärseitige Stromquelle, mit der der Sekundärwicklung (3) ein Kompensationsstrom aufgeprägt wird, der dem durch den Primärstrom in der Sekundärwicklung (3) bewirkten Strom gleich, jedoch entgegengesetzt gerichtet ist.

4. Strom-Meßeinrichtung nach Anspruch 3,
**dadurch gekennzeichnet,**
daß der Stromwert des Kompensationsstromes als Meßgröße für den Primärstrom erfaßt wird.

5. Strom-Meßeinrichtung nach Anspruch 3 oder 4,
**dadurch gekennzeichnet,**
daß die Stromquelle einen Operationsverstärker (4) umfaßt.

6. Strom-Meßeinrichtung nach einem der Ansprüche 3 bis 5,
**dadurch gekennzeichnet,**
daß die Anschlüsse der Sekundärwicklung (3) mit den Eingängen des Operationsverstärkers (4) verbunden sind.

7. Strom-Meßeinrichtung nach Anspruch 5 oder 6,
**dadurch gekennzeichnet,**
daß der Operationsverstärker (4) einen Rückkoppelzweig (6) aufweist, dessen Rückkoppelstrom der Sekundärwicklung (3) aufgeprägt wird.

8. Strom-Meßeinrichung nach Anspruch 7,
**dadurch gekennzeichnet,**
daß der Rückkoppelzweig (6) einen Meßwiderstand (7) aufweist, an dem eine dem Rückkoppelstrom proportionale Spannung abgreifbar ist.

9. Strom-Meßeinrichtug nach Anspruch 3 bis 5,
**dadurch gekennzeichnet,**
daß der Meßwiderstand (7) in seinem Widerstandswert umschaltbar ist.

10. Strom-Meßeinrichtung nach einem der Ansprüche 5 bis 8,
**dadurch gekennzeichnet,**
daß wenigstens ein Eingangszweig des Operationsverstärkers (4) eine Schaltungsstufe (8, 9) zur Gleichtaktunterdrückung aufweist.

11. Stom-Meßeinrichtung nach einem der Ansprüche 3 bis 10,
**dadurch gekennzeichnet,**
daß der Übertrager (1) eine zweite Sekundärwicklung (10) aufweist, über die der Kompensationsstrom fließt.

12. Strom-Meßeinrichtung nach einem der Ansprüche 3 bis 11,
**dadurch gekennzeichnet,**
daß zwischen der sekundärseitigen Stromquelle und wenigstens einer Sekundärwicklung (3) eine Gleichrichterschaltung (11, 12, 13, 14) vorgesehen ist.

13. Strom-Meßeinrichtung nach einem der Ansprüche 3 bis 12,
**dadurch gekennzeichnet,**
daß mehrere, an unterschiedlichen Meßorten vorgesehene Übertrager (1, 15, 16) wahlweise mit derselben sekundärseitigen Stromquelle verbindbar sind.

14. Strom-Meßeinrichtung nach Anspruch 13,
gekennzeichnet durch eine Bus-Leitung zur Verbindung der an unterschiedlichen Meßorten angeordneten Übertrager mit der sekundärseitigen Stromquelle.
